Europäisches Patentamt

European Patent Office

Office européen des brevets

(19)

(11) Veröffentlichungsnummer: **0 204 189**
B1

## (12) EUROPÄISCHE PATENTSCHRIFT

(45) Veröffentlichungstag der Patentschrift:
13.12.89

(21) Anmeldenummer: 86106584.5

(22) Anmeldetag: 15.05.86

(51) Int. Cl.⁴: **C25D 11/32**, C30B 33/00,
C30B 29/06

(54) Verfahren zum mechanisch-chemischen Polieren von Siliciumscheiben.

(30) Priorität: 15.05.85 DE 3517665

(43) Veröffentlichungstag der Anmeldung:
10.12.86 Patentblatt 86/50

(45) Bekanntmachung des Hinweises auf die Patenterteilung:
13.12.89 Patentblatt 89/50

(84) Benannte Vertragsstaaten:
DE FR GB IT

(56) Entgegenhaltungen:
US-A- 2 909 470

CHEMICAL ABSTRACTS, Band 68, Nr. 6, 1968,
Seiten 2514,2515, Zusammenfassung Nr. 26119z,
Columbus, Ohio, US; V.I. KOVAL'CHUK et al.: "Effect of
the surface treatment of silicon on its anodic oxide
coating process", & FIZ. SVOISTVA OSOBO CHIST.
METAL. POLUPROV. AKAD. NAUK UZB. SSR,
FIZ.-TEKH. INST. 1966, 65-77 000
JOURNAL OF THE ELECTROCHEMICAL SOCIETY,
Band 120, Nr. 4, April 1973, Seiten 526-532; M. CROSET
et al.: "Anodic oxidation of silicon in organic baths
containing fluorine"

(73) Patentinhaber: Wacker-Chemitronic Gesellschaft für
Elektronik-Grundstoffe mbH,
Johannes-Hess-Strasse 24, D-8263 Burghausen(DE)

(72) Erfinder: Lampert, Ingolf, Kettelerstrasse 21,
D-8263 Burghausen(DE)
Erfinder: Jacob, Herbert, Dr., Marienberger Strasse 17,
D-8263 Burghausen(DE)

## Beschreibung

Die Erfindung betrifft ein Verfahren zum mechanisch-chemischen Polieren von Siliciumscheiben.

Für das mechanisch-chemische Polieren von Siliciumscheiben ist eine Reihe von Verfahren bekannt geworden; beispielhaft seien nur die Verfahren gemäß DE-OS 2 305 188 oder DE-OS 2 531 431 genannt.

Den bekannten Verfahren ist gemeinsam, daß die polierten Scheiben in dem Zeitraum zwischen dem Ende des eigentlichen Poliervorgangs und dem abschließenden Trocknen und Verpacken einer Fülle von Einflüssen ausgesetzt sind, beispielsweise unkontrollierten chemischen Reaktionen durch anhaftende Reste des in der Regel alkalischen Poliermittels, durch Reinigungslösungen, oder Wasser. Diese Einflüsse können eine Verschlechterung der Oberflächenqualität bewirken, die sich bei der Überprüfung der Oberfläche im gebündelten Licht als sogenannter "Schleier" bemerkbar macht, d.h. als milchig-graue Flächen am Auftreffpunkt, die durch die Streuung des Lichts an geringfügig aufgerauhten Flächenbereichen hervorgerufen werden. Von den Herstellern elektronischer Bauelemente wird jedoch, vor allem im Hinblick auf die wegen der immer weiter fortschreitenden Miniaturisierung steigenden Anforderungen an die Oberflächenqualität, größter Wert auf schleierfreie Siliciumscheiben gelegt, die also derartige, mit Hilfe des "Schleiers" nachweisbare Einflüsse auf die Oberflächenqualität nicht aufweisen.

Weiterhin ist aus Chemical Abstracts, Band 68, Nr. 6, 1968, Seiten 2514, 2515; Zusammenfassung Nr. 261 192 ein Verfahren bekannt, bei dem Siliciumscheiben einer Abfolge von mechanischen, chemischen und elektrochemischen Polierschritten unterworfen werden. Dabei werden die beiden letztgenannten Teilschritte jedoch in speziellen Bädern durchgeführt.

Die Aufgabe der Erfindung lag darin, ein Verfahren zum mechanisch-chemischen Polieren von Siliciumscheiben anzugeben, welches es gewährleistet, daß durch die sich an den Poliervorgang anschließenden Arbeitsvorgänge die Oberflächenqualität der polierten Scheiben nicht mehr beeinträchtigt werden kann.

Gelöst wird die Aufgabe durch ein Verfahren, welches dadurch gekennzeichnet ist, daß der Poliervorgang in Gegenwart eines alkalischen Poliermittels durchgeführt und mit einer Behandlung beendet wird, bei der während des Polierens auf der Siliciumoberfläche ein Siliciumdioxidfilm erzeugt wird.

Dies läßt sich auf besonders einfache Weise dadurch erreichen, daß am Ende des Poliervorganges dem auf die Arbeitsfläche fließenden, in der Regel alkalischen Poliermittel ein Oxidationsmittel oder Oxidationsmittelgemisch zugeführt wird, dessen Potential in alkalischer Lösung gegenüber der Standard-Wasserstoffelektrode mindestens 0,52 Volt beträgt. Solche Oxidationsmittel sind beispielsweise Permanganate, Peroxodisulfate, Hypobromite, Hypochlorite oder Wasserstoffperoxid. Bevorzugt werden die Oxidationsmittel in Form von Verbindungen eingesetzt, welche keine zusätzlichen Fremdkationen in das Poliersystem einbringen, also hauptsächlich als Natrium-, Kalium-, oder, falls sie beständig sind, Ammoniumsalze. Diese Kationen sind in der Regel unschädlich, da im allgemeinen auch das Poliermittel Kalium-, Natrium-, oder Ammoniumverbindungen enthält. Mit besonderem Vorteil wird jedoch Wasserstoffperoxid eingesetzt, durch welches naturgemäß keine zusätzlichen Fremdionen eingeschleppt werden können.

In den meisten Fällen ist es ausreichend, dem Poliermittel die oxidierende Komponente in einer Menge zuzusetzen, daß ihr Anteil etwa 0,1 bis 2 Volumenprozent, bezogen auf vorgelegtes Poliermittel, beträgt. Höhere Anteile sind zwar grundsätzlich nicht ausgeschlossen, ergeben jedoch zumeist keine besseren Resultate. Zweckmäßig werden die Oxidationsmittel in Form von wäßrigen Lösungen zugegeben.

Nach Zusatz der oxidierenden Komponente zum Poliermittel genügt es in der Regel, den Poliervorgang unter ansonsten unveränderten Bedingungen für kurze Zeit, beispielsweise 0,5 bis 5 Minuten, vorzugsweise ein bis zwei Minuten fortzusetzen. Diese Zeit reicht erfahrungsgemäß aus, daß durch den Angriff des Oxidationsmittels die polierte Fläche mit einer gleichmäßigen Siliciumdioxidschicht überzogen wird. Mit den genannten oxidierenden Elementen lassen sich im allgemeinen dabei Schichtdicken erzielen, die im Bereich von 1–5 nm (10–50 Å) liegen. Selbst dieser äußerst dünne Oxydfilm verhindert in den meisten Fällen nach Beendigung des Poliervorganges weitere unkontrollierte Reaktionen, die die darunterliegende, einwandfreie polierte Scheibenoberfläche ungünstig beeinflussen könnten.

Die bisher genannten, rein chemischen Oxidationsmethoden sind im Grunde mit den zum Beispiel von Aluminiumoberflächen her bekannten Passivierungsvorgängen zu vergleichen. Dementsprechend lassen sich auf diese Art und Weise Oxidfilme nicht in beliebig großen Dicken aufbringen, sondern erfahrungsgemäß selbst bei langer Einwirkungsdauer des Oxidationsmittels nur bis zu einem bestimmten Grenzwert, meist im Bereich von weniger als 5nm (50 Å).

Demgegenüber größere Schichtdicken des Oxidfilmes können jedoch durch anodische Oxidation der polierten Siliciumoberfläche erreicht werden. Die erforderliche Potentialänderung kann dabei beispielsweise in einem Schaltkreis – mit der zu polierenden Scheibe als Anode und dem Polierteller als Kathode- eingestellt werden, der über das mit einem ionisch leitenden Poliermittel gesättigte Poliertuch geschlossen ist. Als Poliermittel kommen für diesen Zweck beispielsweise die üblicherweise beim Polieren von Siliciumscheiben im alkalischen Medium eingesetzten Mittel in Frage.

Grundsätzlich kann auch während des anodischen Oxidationsschrittes der Poliervorgang unter ansonsten gleichen Bedingungen weitergeführt werden. Günstiger ist es jedoch, durch geeignete Maßnahmen z. B. Erniedrigung des Druckes und/oder der Temperatur, die Abtragsraten zu verkleinern, da sich dann auch die benötigten Spannungen und Stromdichten verringern lassen. Geeignete Parameter werden zweckmäßig an Hand von Vorversuchen ermittelt; allgemein haben sich für die anodische Oxidation Spannungen von -1 bis +2 Volt (gemessen gegen eine Kolomelelektrode) und Stromdichten von 0,1 bis 5 mA/cm² als zweckmäßig erwiesen. wenngleich auch der Einsatz höherer Spannungen und Stromdichten nicht ausgeschlossen ist, beispielsweise wenn eine besonders rasche Oxidation angestrebt wird.

Grundsätzlich ermöglicht das anodische Oxidationsverfahren zwar gegenüber dem Zusatz von chemische Oxidationsmitteln beim Polieren höhere Dicken der Siliciumdioxidschicht, erfordert aber gleichzeitig einen vergleichsweise höheren apparativen Aufwand. Man wird daher dieses Verfahrens hauptsächlich dann einsetzen, wenn Siliciumscheiben erwünscht sind, die über ihrer polierten Fläche einen Siliciumdioxidfilm mit einer Dicke besitzen, die mit der chemischen Oxidationsmethode nicht oder nur mit großem Aufwand erzielt werden kann. Ansonsten wird man auf die einfachere und apparativ weniger aufwendige Methode des Oxidationsmittelzusatzes zurückgreifen. Ein besonderer Vorteil dieses Verfahrens liegt darin, daß der Zusatz der oxidierenden Komponente zumeist eine deutliche Verringerung des Polierabtrages mit sich bringt, so daß die erwünschte Bildung der Oxidschicht nicht durch starken Abtrag gestört wird.

Das erfindungsgemäß Verfahren gestattet es damit - und zwar sowohl beim Ein- als auch doppelseitigen Polieren - bei Siliciumscheiben die im Laufe des Poliervorganges erreichte hohe Qualität der polierten Oberfläche durch die Beschichtung unmittelbar bei Abschluß des Polierens in diesem Zustand zu konservieren. Die nachfolgenden Bearbeitungsvorgänge, wie z. B. Reinigen, Spülen, Trocknen usw. können dann nämlich nicht mehr direkt auf diese Fläche einwirken, sondern nur noch auf den aufgebrachten Schutzfilm aus Siliciumdioxid.

Damit steht für die sich bei der Herstellung elektronischer Bauelemente anschließenden Verfahrensschritte die Siliciumoberfläche als solche in einwandfrei poliertem, ungestörtem Zustand zur Verfügung. Oxidationsprozesse, z. B. thermischer Art, werden durch den äußerst dünnen, darüberliegenden Siliciumdioxidfilm nicht beeinträchtigt, ebensowenig wie Reinigungsschritte wie z. B. Entstaubung. Andererseits kann der Oxidfilm nötigenfalls durch kurzzeitiges Anätzen, z. B. mit Flußsäure, leicht wieder entfernt werden, um die Siliciumoberfläche offenzulegen.

Das erfindungsgemäße Verfahren wird durch die nachstehenden Ausführungsbeispiele näher erläutert.

Beispiel 1:

12 Siliciumscheiben (Ø 125 mm) wurden mittels einer leitfähigen Haftfolie kittfrei auf einer üblichen Trägerplatte befestigt, welche anschließend in eine übliche Poliermaschine eingesetzt wurde. Über Schleifkontakte konnten die Trägerplatte mitsamt den aufliegenden Siliciumscheiben anodisch gepolt werden. Als Gegenelektrode konnte der Polierteller geschaltet werden, und über das darüber gespannte, mit Poliermittel getränkte Poliertuch konnte der Stromkreis geschlossen werden.

Nun wurde zunächst ca. 25 Minuten lang ohne Anlegen einer Spannung bei üblichen Polierbedingungen (Druck ca. 500 h Pa (0,5 bar), Temperatur etwa 50°C) unter fortgesetzter Zufuhr eines handelsüblichen alkalischen Poliermittels auf Kieselsäuresolbasis bei einem pH-Wert von etwa 11,5 poliert, bis ein Abtrag von etwa 40 µm erreicht war. Nun wurde der Stromkreis geschlossen (Spannung ca. 0,9 Volt, Stromdichte ca. 2,5 mA/cm²) und gleichzeitig der Druck auf 100 h Pa (0,1 bar) vermindert. Unter diesen Bedingungen wurde der Poliervorgang 2 Minuten lang fortgesetzt, wobei nahezu kein weiterer Polierabtrag mehr festzustellen war.

Nach Beendigung des Polierens wurden die Scheiben noch für weitere 30 Minuten in der ruhenden Poliermaschine belassen, um das Poliermittel weiter einwirken zu lassen. Anschließend wurden sie entnommen und gereinigt; mit Hilfe eines Ellipsometers wurde die Dicke der aufgebrachten Siliciumdioxidschichten zu 9 nm (90 Å) bestimmt.

Bei drei dieser Scheiben wurde nun durch Anätzen mit Flußsäure die Oxidschicht wieder entfernt. Im gebündelten Licht erwies sich die freigelegte Siliciumoberfläche als völlig schleierfrei.

In der gleichen Weise wurden nun 12 weitere Scheiben poliert, aber ohne den anodischen Oxidationsschritt nach Beendigung des Poliervorganges für weitere 30 Minuten in der ruhenden Poliermaschine der Einwirkung des Poliermittels ausgesetzt. Nach Entnahme und Reinigung zeigte die polierte Oberfläche dieser Scheiben deutliche Schleier.

Beispiel 2:

Zu einer Apparatur zum beidseitigen Polieren von Siliciumscheiben wurden 8 Siliciumscheiben (Durchmesser 125 mm, (100)-Orientierung) unter üblichen Polierbedingungen (Polierdruck ca. 500 h Pa (0,5 bar), Temperatur ca. 50°C) poliert. Zunächst wurde während des 20-minütigen Poliervorganges ein handelsübliches alkalisches Poliermittel auf Kieselsäuresolbasis aus einem Vorratsgefäß auf das Poliertuch gepumpt. Danach wurde dem Poliermittel im Vorratsgefäß eine 30%ige Lösung von Wasserstoffperoxid zugesetzt, bis eine Konzentration von 1 Vol.-% Peroxid im Poliermittel erreicht war.

Ohne Unterbrechung wurde der Poliervorgang unter weiterer Zufuhr des nunmehr peroxidhaltigen Poliermittels unter ansonsten gleichen Bedingungen noch eine Minute fortgesetzt. Dabei verringerte sich der Polierabtrag deutlich, und die Scheiben überzogen sich mit einem dünnen Film aus Siliciumdioxid.

Nach Beendigung des Polierens wurden die Scheiben entnommen und von anhaftenden Poliermittelresten befreit. Mittels eines Ellipsometers wurde die Dicke der auf ihre Oberfläche aufgebrachten Oxidschicht ermittelt; sie betrug 1,8 nm (18 Å). Bei der Überprüfung im gebündelten Licht erwiesen sich beide Scheibenoberflächen als völlig schleierfrei.

Bei einer weiteren Polierfahrt wurden 8 Scheiben der gleichen Spezifikation in derselben Weise behandelt, jedoch ohne Wasserstoffperoxidzusatz am Ende des Poliervorganges. Drei der so erhaltenen Scheiben zeigten bei der Kontrolle im gebündelten Licht auf einer Oberfläche den sog. "Schleier".

## Patentansprüche

1. Verfahren zum mechanisch-chemischen Polieren von Siliciumscheiben, dadurch gekennzeichnet, daß der Poliervorgang in Gegenwart eines alkalischen Poliermittels durchgeführt und mit einer Behandlung beendet wird, bei der während des Polierens auf der Siliciumoberfläche ein Siliciumdioxidfilm erzeugt wird.

2. Verfahren nach Anspruch 1, dadurch gekennzeichnet, daß als Siliciumdioxidfilm, eine Siliciumdioxidschicht von mindestens 1 nm (10 Å) Dicke erzeugt wird.

3. Verfahren nach den Ansprüchen 1 und 2, dadurch gekennzeichnet, daß der Siliciumdioxidfilm durch anodische Oxidation vermittels einer Spannungsquelle in einem Schaltkreis mit anodisch gepolten Siliciumscheiben erzeugt wird.

4. Verfahren nach den Ansprüchen 1 und 2, dadurch gekennzeichnet, daß der Siliciumdioxidfilm mit Hilfe von Oxidationsmitteln erzeugt wird, deren gegenüber einer Standardwasserstoffelektrode gemessenes Potential in alkalischer Lösung größer ist als 0,52 Volt.

5. Verfahren nach Anspruch 4, dadurch gekennzeichnet, daß die Oxidationsmittel ausgewählt werden aus der Gruppe der Permanganate, Peroxodisulfate, Hypobromite, Hypochlorite oder Wasserstoffperoxid.

## Claims

1. Process for the mechanical-chemical polishing of silicon wafers, characterized in that the polishing operation is carried out in the presence of an alkaline polishing agent and is terminated with a treatment in which a silicon dioxide film is produced on the silicon surface suring the polishing.

2. Process as claimed in Claim 1, characterized in that a silicon dioxide layer at least 1 nm (10 Å) thick is produced as silicon dioxide film.

3. Process according to Claims 1 and 2, characterized in that the silicon dioxide film is produced by anodic oxidation by means of a voltage source in a circuit with silicon wafers anodically polarized.

4. Process according to Claims 1 and 2, characterized in that the silicon dioxide film is produced with the aid of oxidizing agents whose potential measured against a standard hydrogen electrode in alkaline solution is greater than 0.52 volts.

5. Process according to Claim 4, characterized in that the oxidizing agents are selected from the group comprising permangates, peroxodisulphates, hypobromites, hypochlorites or hydrogen peroxide.

## Revendications

1. Procédé pour polir mécaniquement-chimiquement des disques en silicium, procédé caractérisé en ce qu'on conduit le processus de polissage en présence d'un agent alcalin de polissage et en ce qu'on termine par un traitement dans lequel on obtient, pendant le polissage, une pellicule de bioxyde de silicium sur la surface en silicium.

2. Procédé selon la revendication 1, caractérisé en ce qu'on produit, comme pellicule de bioxyde de silicium, une couche de bioxyde de silicium ayant au moins 1 nm (10 Å) dépaisseur.

3. Procédé selon les revendications 1 et 2, caractérisé en ce qu'on produit la pellicule de bioxyde de silicium par oxydation anodique obtenue à l'aide d'une source de tension dans un circuit dans lequel les disques en silicium ont une polarité anodique.

4. Procédé selon les revendications 1 et 2, caractérisé en ce qu'on produit la pellicule de bioxyde de silicium à l'aide d'agents d'oxydation dont le potentiel, mesuré par rapport à une électrode normale d'hydrogène, est en solution alcaline supérieur à 0,52 V.

5. Procédé selon la revendication 4, caractérisé en ce que les agents d'oxydation sont choisis parmi les permanganates, les peroxodisulfates, les hypobromites, les hypochlorites ou le peroxyde d'hydrogène.